# EUROPEAN PATENT SPECIFICATION

(11) **EP 2 384 108 B1**
(45) Date of publication and mention of the grant of the patent: **15.01.2014**
(21) Application number: 10161155.6
(22) Date of filing: 27.04.2010
(51) Int. Cl.: H05K 7/20, H01L 23/467

(54) **Dust-disposal heat-dissipation device with double cooling fans**
Staubentsorgungswärmeableitvorrichtung mit Doppelkühlgebläse
Dispositif de dissipation thermique à dépôt de poussière avec ventilateurs doubles

(43) Date of publication of application: 02.11.2011
(73) Proprietor: Giga-Byte Technology Co., Ltd., New Taipei City 231 (TW)
(72) Inventor: Huang, Shun-Chih, 231, Hsin Tien, taipei County (TW); Mao, Tai-Chuan, 231, Hsin Tien, Taipei County (TW)
(74) Representative: Schwerbrock, Florian

(56) References cited:
- DE-U1-202004 009 233
- US-A- 5 953 209
- US-A- 6 101 459
- US-A1- 2009 009 960
- US-A1- 2010 025 014
- US-A1- 2010 067 194
- US-B2- 7 630 201

## Description

### BACKGROUND OF INVENTION

### 1. Field of Invention

The present invention relates to a heat dissipation device having double cooling fans, and in particular to the one with dust removal function.

### 2. Related Prior Art

Computer components often exude a large amount of heat during operation of the computer system. In order to keep the components within their safe operating temperatures, heat generated by the components must be dissipated. Varied cooling apparatuses are used to remove heat from computer components.

Taiwan Patent No. 371497 is exemplary of patent directed to a dual-fan heat dissipation device of the type to which this invention is directed. The dissipation device mainly includes two cooling fans and a fan control module for controlling rotation of the cooling fans. One of the fans is arranged to draw cooler air into a computer chassis from outside while the other fan is to exhaust hot air out of the computer chassis. The fan control module is configured to enable the fans to run in turn. That is, when one fan rotates, the other stops, and they take turns. In this manner, resonance effect, which is often caused by a dual-fan device in a computer system, may be reduced, and thereby the noise is diminished. However, the dual-fan heat dissipation device as described in that patent has no dust removal function.

Another heat dissipation device is described in U.S. Pat. No. 7,630,201 and includes two fans which take turns to rotate in the opposite direction to keep a heat sink cool. However, the fans are not able to run together at the same time for cooling the heat sink, and therefore the heat dissipation efficiency of the same is limited.

Furthermore, the document US5,953,209A discloses a heat dissipation device using two fans in a push pull configuration. The document US20089/0009960A1 discloses a heat dissipation device which prevents dust accumulation by reversing the fans of the device. The document US2010/0067194A1 discloses a heat dissipation device comprising a single fan without a dust removal function.

### SUMMARY OF INVENTION

Broadly stated, the present invention is directed to a dual-fan heat dissipation device with a dust removal function. The heat dissipation device generally includes a fin set, a cover, a first cooling fan, a second cooling fan and a control module. The fin set includes a plurality of cooling fins alongside each other. The cover has a main plate which covers a top of the fin set. The first and second cooling fans are disposed on the cover. Upon being actuated, the first cooling fan is able to generate airflow toward a front top section of the fin set. Likewise, the second cooling fan is able to generate airflow toward a rear top section of the fin set upon being actuated. The control module is configured to either actuate the first and second fans upon receiving a working signal or execute the following steps upon receiving a dust-disposal signal:
(a). turning on the first cooling fan and turn off the second cooling fan simultaneously for a period of time; and
(b). turning on the second cooling fan and turn off the first cooling fan simultaneously for a period of time.

By virtue of the control module, during the time period of step (a), the first cooling fan generates airflow to have a heat exchange with the cooling fins of the fin set, as well as to remove dust from the fin set and the second cooling fan. In like manner, the second cooling fan is able to generate airflow to cool the fin set and remove dust from the fin set and the first cooling fan simultaneously during the time period of step (b). In particular, in the aforementioned steps, the first and second cooling fans each rotates in the same direction without reverse rotation.

After the step (a) but before the step (b), the control module further executes the step of simultaneously turning on the first and second cooling fans. In this way, while the control module is shifting from step (a) to the step (b), a situation where both the first and second cooling fans are both shut down can be avoided.

In addition, the fin set has a substantially flat section, a front inclined section and a rear inclined section at a bottom thereof. The flat section is defined for contacting a heat source. The front and rear inclined sections are located at opposite sides of the flat section. The front inclined section faces obliquely toward the first cooling fan. The rear inclined section faces obliquely toward the second cooling fan. Besides, the front and rear inclined sections are slanted toward the flat section. As such, the rear inclined section is able to direct air toward the second cooling fan in step (a) and the front inclined section toward the first cooling fan in step (b).

Further features and advantages of the present invention will be appreciated by review of the following detailed description of the invention.

### BRIEF DESCRIPTION OF DRAWINGS

The invention is illustrated by the accompanying drawings in which corresponding parts are identified by the same numerals and in which:
FIG. 1 is a perspective view of a circuit board and an embodiment of a heat dissipation device in according with the present invention;
FIG. 2 is another perspective view, partially exploded to show details of a bottom of a fin set of the heat dissipation device;
FIG. 3 is a cross-sectional view of the heat dissipation device, showing the route of airflow when the two cooling fans are both in working states;
FIG. 4 is another cross-sectional view of the heat dissipation device, showing the route of airflow when only the left fan is in the working state; and
FIG. 5 is a view similar to FIG. 4, showing the route of airflow when only the right cooling fan is in the working state.

### DETAILED DESCRIPTION OF PREFERRED EMBODIMENT

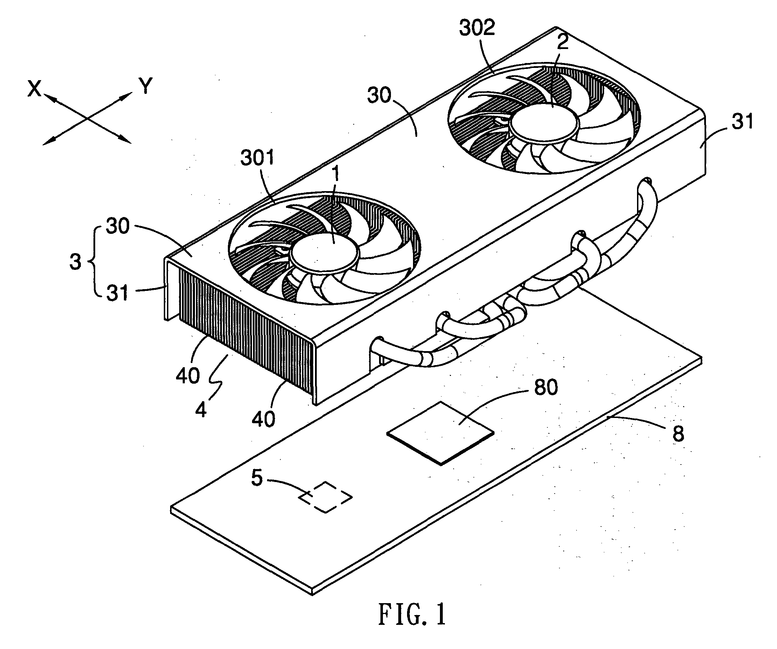

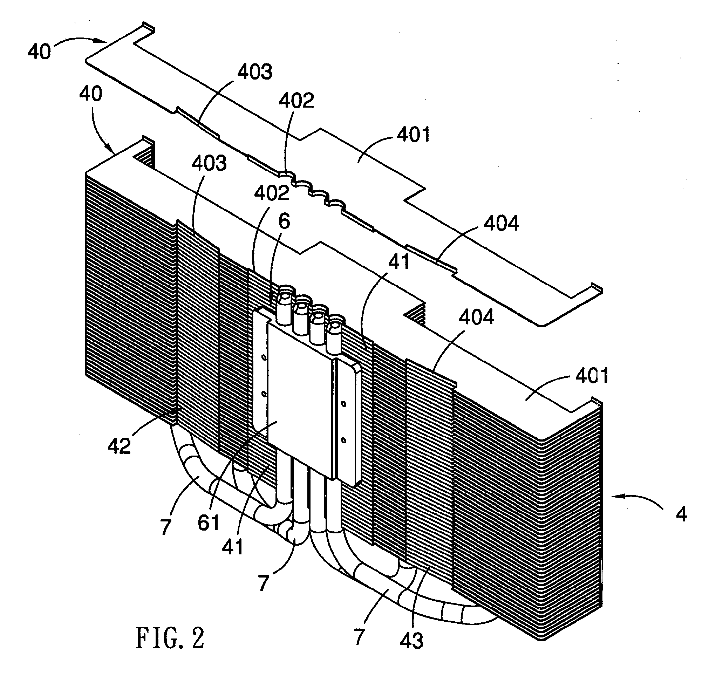

Turning in detail to the drawings, a heat dissipation device is illustrated in FIGS. 1 and 2 in accordance with the preferred embodiment of the invention. The heat dissipation device includes a first cooling fan 1, a second cooling fan 2, a cover 3, a fin set 4 and a control module 5. Note that, in this embodiment, the control module 5 is integrated on a printed circuit board 8.

As shown in FIG. 1, the fin set 4 includes a plurality of cooling fins 40 spaced apart in a transverse direction X. Channels are defined between adjacent cooling fins 40. The cover 3 includes a main plate 30 and two baffles 31 extending downward from opposite sides of the main plate 30. The main plate 30 coves a top surface of the fin set 4 and has two inlets 301 and 302 defined therein and spaced apart in a longitudinal direction Y. The first cooling fan 1 is mounted in the inlet 301 of the cover 3. Upon being actuated, the first cooling fan 1 is able to generate airflow toward a front top section of the fin set 4. Similarly, the second cooling fan 2 is mounted in the other outlet 302 of the cover 3 and is able to generate airflow toward a rear top section of the fin set 4 upon being actuated.

The control module 5 is generally composed of a micro controller and some transistor switch circuits, as will be described later.

As shown in FIG. 2, the fin set 4 has a substantially flat section 41 at the bottom thereof for contacting a heat source 6. In this example, the heat source 6 includes a heat conductive block 61 and heat absorption sections of some heat pipes 7. In another example, the heat source 6 may be a CPU, a GPU or other heat-generating components.

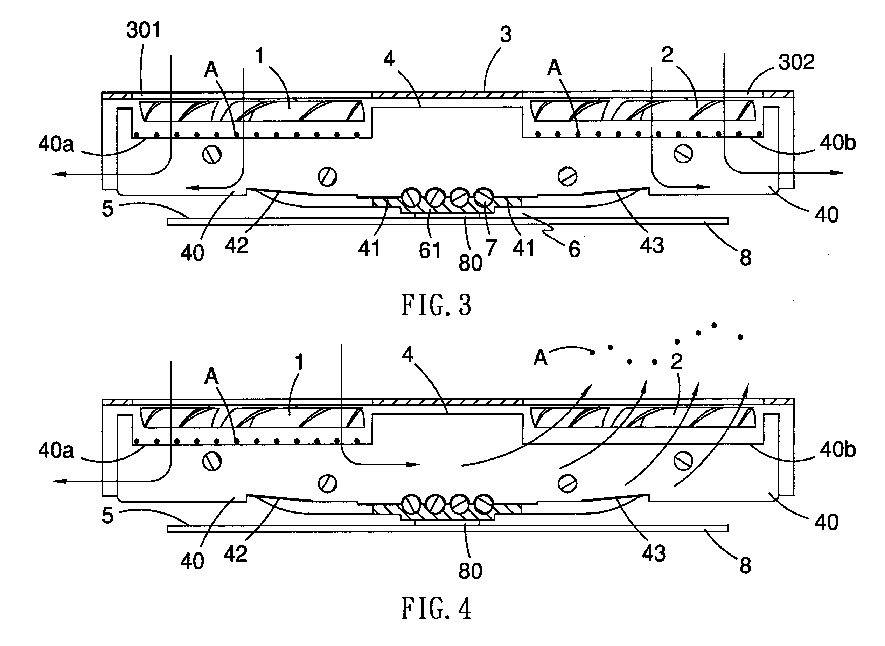

As shown in FIG. 3, the flat section 41 of the fin set 4 contacts the heat source 6. The heat conductive block 61 of the heat source 6 abuts against a chip 80 of the circuit board 8. Therefore, heat generated by the chip 80 can be transferred by the heat conductive block 61 and the heat pipes 7 to the fin set 4 for further dissipation.

As can be seen in FIGS. 3-5, the circuit board 8 is a computer display card inside a computer host. The chip 80 is a GPU integrated on the computer display card. The control module 5 is integrated on the circuit board 8 and is coupled to the first and second cooling fans 1, 2 for power control over the two cooling fans 1, 2 in order to selectively turn on or off the first and second cooling fans 1, 2. Most importantly, the control module 5 is configured to either actuate the first and second fans 1, 2 upon receiving a working signal or execute the following steps upon receiving a dust-disposal signal:
(a). turning on the first cooling fan 1 and turn off the second cooling fan 2 simultaneously; and
(b). turning on the second cooling fan 2 and turn off the first cooling fan 1 simultaneously.

It is noted that each of the steps (a) and (b) is executed for a predetermined period of time, such as dozens of seconds or minutes.

There are a number of ways to generate the working signal. For instance, a push by a user via a quick launch button of a keyboard of the computer host enables the computer host to generate a working signal. In another way, a working signal may also be generated by a program which drives the computer host to generate the same. In yet another way, the computer host may be required to generate a working signal when a temperature inside the computer host is detected by a temperature sensor and the temperature value is above a criterion.

Similarly, there are a number of ways to generate a dust-disposal signal. For instance, by a push of another button (such as a button special created for dust removal) on the computer host or another quick launch button. In another way, a dust-disposal signal may be generated by the computer host by means of a computer program. In yet another way, the computer host may be required to generate a dust-disposal signal once a total operating time value of the first and second cooling fans is up to a predetermined standard value.

In any case, upon receiving the working signal, the control module 5 immediately actuates the first and second cooling fans 1, 2 for heat dissipation. That is, the control module 5 allows the first and second cooling fans 1, 2 to be powered in such a way that the first and second cooling fans 1, 2 are able to generate airflow, as shown by arrows in FIG. 3. In this state, the first and second cooling fans 1, 2 are operating for heat dissipation from the circuit board 8 and the chip 80. As can be seen from arrows in FIG. 3, particles A, such as dust or feather dust, are remained on a surface of the fin set 4, namely a front top edge 40a and a rear top edge 40b, which face the direction of the airflow. Besides, on the surfaces of the fan blades of the first and second cooling fans 1, 2 are particles (not shown) too.

In particular, once the control module 5 receives the dust-disposal signal, the control module 5 executes the aforementioned steps (a) and (b) to cast out those particles. Firstly, in step (a), the first cooling fan 1 is turned on and working while the second cooling fan 2 is turned off and stops working, under the control of the control module 5. At this time, the first cooling fan 1 generates airflow as shown by arrows in FIG. 4. According to the direction of the airflow in FIG. 4, those particles A accumulated on the rear top edge 40b of the fin set 4 as well as the particles which are on the blades of the second cooling fan 2 are blew off by the airflow of the first cooling fan 1. Note that, in addition to the dust removal, the first cooling fan 1, in the meanwhile, runs for heat dissipation.

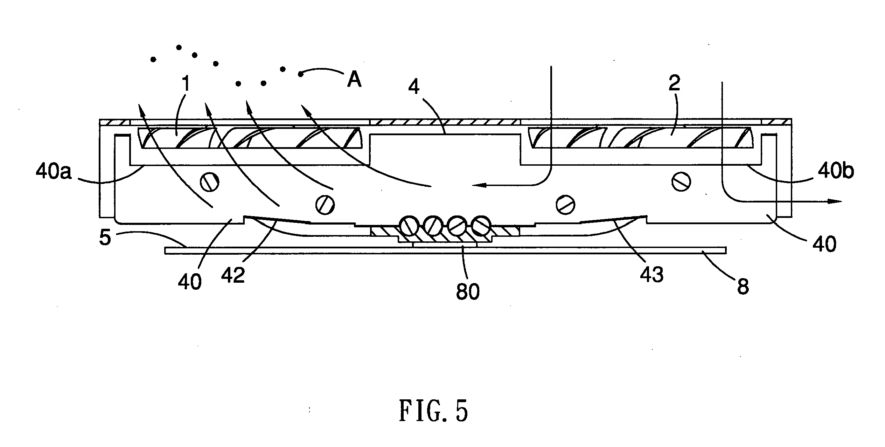

Secondly, in step (b), the first cooling fan 1 is turned off and stops working under the control of the control module 5. However, the second cooling fan 2 is turned on by the control module 5 and starts to run to generate airflow as shown by arrows in FIG. 5. According to the direction of the airflow in FIG. 5, those particles A accumulated on the front top edge 40a of the fin set 4 as well as the particles which are on the blades of the first cooling fan 1 are blew off by the airflow of the second cooling fan 2. Also note that, in addition to the dust removal, the second cooling fan 2, in the meanwhile, runs for heat dissipation.

As described above, when the computer host generates the dust-disposal signal, the control module 5 receives the signal and then executes the steps (a) and (b) to enable the first and second cooling fans 1, 2 to remove the dust in turn. If necessary, the control module 5 can further executes another round of the steps (a) and (b) each for a while and repeats that over and over again. Anyhow, it can be understood that, by virtue of the control of the control module 5 over the first and second cooling fans 1, 2, the fin set 4 as well as the first and second cooling fans 1, 2 can be kept clean without dust accumulation, which has significant positive effect on the heat-dissipation-efficiency of the entire heat dissipation device.

It should be noted that when being actuated by the control module 5 to execute the regular heat dissipation process, the two cooling fans 1, 2 both rotate in a rotational direction. In addition to that, in response to the dust-disposal signal, the control module 5 drives the first and second cooling fans 1, 2 to continue rotating in the same rotational direction. These greatly differ from the prior arts where the cooling fans are constructed to rotate reversely for dust removal purpose.

While the first and second cooling fan 1, 2 are taking turns to run as mentioned in the steps (a) and (b), it may happen that the two cooling fans 1, 2 are shutting down simultaneously in a short time. This may happened due to a circuit delay, for example. Sometimes the result, because of the short shutdown, could also be incorrectly deemed as a problem by a user. In this regard, the control module 5 may be further configured to execute the step of simultaneously turning on the first and second cooling fans 1, 2, after the step (a) but before the step (b), so as to prevent the two cooling fans 1, 2 from shutting down at the same time.

In this preferred embodiment, the control module 5 is integrated on the computer display card; however, in other embodiments, it may also be integrated on a mother board of the computer host. In either way, the resources of GPU on the display card or CPU on the mother board can be employed to replace the micro controller of the control module 5. Alternatively, the control module 5 may be an independent circuit module.

Referring back to FIG. 2, the fin set 4 has the bottom including a front inclined section 42 and a rear inclined section 43 on opposite sides of the flat section 41. The front and rear inclined sections 42, 43 are slanted toward the flat section 41, as shown in FIG. 3. The cooling fins 40 of the fin set 4 are placed side by side and joined together. Each cooling fin 40, substantially fabricated by metal punching process, is made of copper or aluminum. Each cooling fin 40 includes a base plate 401 together with a middle folded edge 402, a front oblique folded edge 403 and a rear oblique folded edge 404 each extending from a bottom of the base plate 401. Those middle folded edges 402 of the cooling fins 40 together define the flat section 41 of the fin set 4. Those front oblique folded edges 403 of the cooling fins 40 together define the front inclined section 42 of the fin set 4. Also, those rear oblique folded edges 404 of the cooling fins 40 together define the rear inclined section 43 of the fin set 4. However, this is simply an example of the fin set 4; and the fin set 4 may be made by any other way, such as by aluminum extrusion process.

Additionally, the front inclined section 42 of the fin set 4 faces obliquely towards the first cooling fan 1 while the rear inclined section 43 of the fin set 4 faces obliquely toward the second cooling fan 2. As shown in FIG. 4, the rear inclined section 43 of the fin set 4 is constructed to guide airflow towards the second cooling fan 2. On the other hand, the front inclined section 42 of the fin set 4 is to guide airflow towards the first cooling fan 1, as depicted in FIG. 5. However, the front and rear inclined sections 42, 43 of the fin set 4 may be deleted from the entire device without substantially affecting performance.

## Claims

1. A heat dissipation device having double cooling fans (1,2), a fin set (4) and a dust removal function for removing dust from the fan blades and the front and rear top edges (40a,40b) of the fin set, the fin set (4) including a plurality of cooling fins (40) with a flat section (41) for contacting a heat source (6), and a front top edge (40a) and a rear top edge (40b) being indentations formed on an opposite side to the flat section (41); the cooling fins (40) extending in a longitudinal direction and spaced apart in a transverse direction with channels, wherein the indentations are rectangular recesses and perpendicular to the longitudinal direction of the fin set (4), and extend through all the cooling fins (40);
a cover (3) including a main plate (30) which covers a top surface of the fin set (4) and has two inlets (301, 302) defined therein, the two inlets (301, 302) being positioned above the indentations and spaced apart corresponding to the front top edge (40a) and the rear edge (40b) of the fin set (4) respectively;
a first cooling fan (1) mounted in one of the two inlets (301) of the cover (3) and located in the front top edge (40a) of the fin set (4) for generating airflow toward the front top edge (40a) of the fin set (4);
a second cooling fan (2) mounted in the other inlet (302) of the cover (3) and located in the rear top edge (40b) of the fin set (4) for generating airflow toward the rear top edge (40b) of the fin set (4); and
a control module (5) configured to either actuate the first and second fans (1, 2) upon receiving a working signal or execute the following steps upon receiving a dust-disposal signal of removing dust from the front top edge (40a) and the rear top edge (40b) of the cooling fins (40):
(a). turning on the first cooling fan (1) and turn off the second cooling fan (2) simultaneously for a period of time; and
(b). turning on the second cooling fan (2) and turn off the first cooling fan (1) simultaneously for a period of time,
wherein the airflow generated by one of the fans can reach the other fan when the fan is switched off
such that in step (a) the dust particles (A) on the blades of the second cooling fan (2) and the rear top edge (40b) are blown off by the airflow of the first cooling fan (1) and that in step (b) the dust particles (A) on the blades of the first cooling fan (1) and the front top edge (40a) are blown off by the airflow of the second cooling fan (2);
wherein after the step (a) but before the step (b), the control module (5) further executes the step of turning on the first and second cooling fans (1, 2) simultaneously, and the airflow exits the heat dissipation device through the channels between the adjacent cooling fins (40) of the fin set (4), and the fin set (4) has open longitudinal ends which are uncovered by the cover (3), and air can leave the channels between the cooling fins (40) at the longitudinal ends of the fin set (4).

2. The heat dissipation device of claim 1, wherein the bottom of the fin set (4) further has a front inclined section (42) and a rear inclined section (43) on opposite sides of the flat section (41); and the front and rear inclined sections (42, 43) face obliquely towards the first and second cooling fans (1, 2) respectively and both are slanted toward the flat section (41).

## Patentansprüche

1. Wärmeabführungsvorrichtung mit doppeltem Kühlgebläse (1, 2), einem Rippensatz (4) und einer Staubabführungsfunktion zur Abführung von Staub von den Gebläseschaufeln und den vorderen und hinteren oberen Kanten (40a, 40b) des Rippensatzes, wobei der Rippensatz (4) Folgendes umfasst:
mehrere Kühlrippen (40) mit einem flachen Bereich (41) für den Kontakt mit einer Wärmequelle (6) und eine vordere obere Kante (40a) und eine hintere obere Kante (40b), die als Vertiefungen an der dem flachen Bereich (41) gegenüberliegenden Seite ausgebildet sind; die Kühlrippen (40) sich in Längsrichtung erstrecken und in Querrichtung in Abständen voneinander angeordnet sind und Kanäle aufweisen, wobei die Vertiefungen rechteckige Aussparungen sind und rechtwinklig zur Längsrichtung des Rippensatzes (4) angeordnet sind und sich über alle Kühlrippen (40) erstrecken;
eine Abdeckung (3) umfassend eine Hauptplatte (30), die eine obere Fläche des Rippensatzes (4) bedeckt und die zwei Einlässe (301, 302) darin aufweist, wobei die zwei Einlässe (301, 302) über den Vertiefungen in Abständen voneinander entsprechend der vorderen oberen Kante (40a) und der hinteren oberen Kante (40b) des Rippensatzes (4) angeordnet sind;
ein erstes Gebläse (1), das in einem der zwei Einlässe (301) der Abdeckung (3) befestigt ist und in der vorderen oberen Kante (40a) des Rippensatzes (4) zur Erzeugung einer Luftströmung in Richtung der vorderen oberen Kante (40a) des Rippensatzes (4) angeordnet ist;
ein zweites Gebläse (2), das im anderen Einlass (302) der Abdeckung (3) eingebaut ist und in der hinteren oberen Kante (40b) des Rippensatzes (4) zur Erzeugung einer Luftströmung in Richtung der hinteren oberen Kante (40b) des Rippensatzes (4) angeordnet ist; und
ein Steuermodul (5), so konfiguriert, dass entweder das erste oder zweite Gebläse (1, 2) betätigt wird, nachdem ein Arbeitssignal empfangen wurde oder die folgenden Schritte durchgeführt werden, nachdem ein Staubabführungssignal zur Abführung von Staub von der vorderen oberen Kante (40a) und der hinteren oberen Kante (40b) der Kühlrippen (40) empfangen wurde:
(a) gleichzeitiges Einschalten des ersten Kühlgebläses (1) und Abschalten des zweiten Kühlgebläses (2) für einen Zeitabschnitt; und
(b) gleichzeitiges Einschalten des zweiten Kühlgebläses (2) und Abschalten des ersten Kühlgebläses (1) für einen Zeitabschnitt, wobei die von einem der Gebläse erzeugte Luftströmung das andere Gebläse erreichen kann, wenn das Gebläse ausgeschaltet ist, in der Art, dass in Schritt (a) die Staubpartikel (A) an den Schaufeln des zweiten Kühlgebläses (2) und der hinteren oberen Kante (40b) von der Luftströmung des ersten Kühlgebläses (1) weggeblasen werden und dass in Schritt (b) die Staubpartikel (A) an den Schaufeln des ersten Kühlgebläses (1) und der vorderen oberen Kante (40a) von der Luftströmung des zweiten Kühlgebläses (2) weggeblasen werden;
wobei nach Schritt (a), aber vor Schritt (b), das Steuermodul (5) ferner den Schritt des Einschaltens der ersten und zweiten Kühlgebläse (1, 2) gleichzeitig durchführt und die Luftströmung aus der Wärmeabführungsvorrichtung durch die Kanäle zwischen den benachbarten Kühlrippen (40) des Rippensatzes (4) austritt, und der Rippensatz (4) offene Längsenden aufweist, die von der Abdeckung (3) nicht abgedeckt werden, und Luft aus den Kanälen zwischen den Kühlrippen (40) an den Längsenden des Rippensatzes (4) austreten kann.

2. Eine Wärmeabführungsvorrichtung nach Anspruch 1, wobei der Boden des Rippensatzes (4) ferner einen vorderen geneigten Bereich (42) und einen hinteren geneigten Bereich (43) an den gegenüberliegenden Seiten des flachen Bereichs (41) aufweist; und die vorderen und hinteren geneigten Bereiche (42, 43) schräg in Richtung der ersten und zweiten Kühlgebläse (1, 2) gegenüber angeordnet sind und beide in Richtung des flachen Bereichs (41) geneigt sind.

## Revendications

1. Un dispositif de dissipation de chaleur
ayant des ailettes de refroidissement doubles (1, 2), un ensemble d'ailettes (4) et une fonction d'élimination de la poussière pour éliminer la poussière des pales du ventilateur et des bords supérieurs avant et arrière (40a, 40b) de l'ensemble d'ailettes, l'ensemble d'ailettes (4) comportant une pluralité d'ailettes de refroidissement (40) de section plate (41) pour entrer en contact avec une source de chaleur (6), et un bord supérieur avant (40a) et un bord supérieur arrière (40b) étant des encoches formées sur un côté opposé à la section plate (41), les ailettes de refroidissement (40) s'étendant dans un sens longitudinal et étant espacées dans un sens transversal par des canaux, où les encoches sont des évidements rectangulaires et perpendiculaires au sens longitudinal de l'ensemble d'ailettes (4) et s'étendent dans toutes les ailettes de refroidissement (40) ;
un capot (3) comprenant une plaque principale (30) qui recouvre une surface supérieure de l'ensemble d'ailettes (4) et comporte deux entrées (301, 302) définies ici, les deux entrées (301, 302) étant positionnées au-dessus des encoches et espacées pour correspondre au bord supérieur avant (40a) et au bord arrière (40b) de l'ensemble d'ailettes (4), respectivement ;
un premier ventilateur de refroidissement (1) monté dans l'une des deux entrées (301) du capot (3) et situé dans le bord supérieur avant (40a) de l'ensemble d'ailettes (4) pour générer un débit d'air vers le bord supérieur avant (40a) de l'ensemble d'ailettes (4);
un deuxième ventilateur de refroidissement (2) monté dans l'autre entrée (302) du capot (3) et situé dans le bord supérieur arrière (40b) de l'ensemble d'ailettes (4) pour générer un débit d'air vers le bord supérieur arrière (40b) de l'ensemble d'ailettes (4), et
un module de commande (5) configuré soit pour actionner le premier et le deuxième ventilateurs (1, 2) à réception d'un signal de travail, soit pour exécuter les étapes suivantes, à réception d'un signal d'élimination de la poussière du bord supérieur avant (40a) et du bord supérieur arrière (40b) des ailettes de refroidissement (40) :
(a). mise en marche du premier ventilateur de refroidissement (1) et arrêt du deuxième ventilateur de refroidissement (2) simultanément pendant une certaine période, et
(b). mise en marche du deuxième ventilateur de refroidissement (2) et arrêt du premier ventilateur de refroidissement (1) simultanément pendant une certaine période, où le débit d'air généré par l'un des ventilateurs peut atteindre l'autre ventilateur lorsque le ventilateur est arrêté, de sorte qu'à l'étape (a) les particules de poussière (A) présentes sur les pales du deuxième ventilateur de refroidissement (2) et le bord supérieur arrière (40b) soient évacuées par le débit d'air du premier ventilateur de refroidissement (1) et que, à l'étape (b), les particules de poussière (A) présentes sur les pales du premier ventilateur de refroidissement (1) et le bord supérieur avant (40a) soient évacuées par le débit d'air du deuxième ventilateur de refroidissement (2) ;
où, après l'étape (a) mais avant l'étape (b), le module de commande (5) continue à exécuter l'étape de mise en marche du premier et du deuxième ventilateurs de refroidissement (1, 2) simultanément, et le débit d'air quitte le dispositif de dissipation de chaleur par les canaux situés entre les ailettes de refroidissement adjacentes (40) de l'ensemble d'ailettes (4), et l'ensemble d'ailettes (4) comporte des extrémités longitudinales ouvertes qui ne sont pas recouvertes par le capot (3), et l'air peut quitter les canaux entre les ailettes de refroidissement (40) au niveau des extrémités longitudinales de l'ensemble d'ailettes (4).

2. Le dispositif de dissipation de chaleur selon revendication 1, où la partie inférieure de l'ensemble d'ailettes (4) comporte par ailleurs une section inclinée avant (42) et une section inclinée arrière (43) sur les côtés opposés de la section plate (41), et les sections inclinées avant et arrière (42, 43) sont obliquement tournées vers le premier et le deuxième ventilateurs de refroidissement (1, 2) respectivement et les deux sont inclinées vers la section plate (41).
